# EUROPEAN PATENT APPLICATION

(11) **EP 4 589 646 A1**
(43) Date of publication of application: **23.07.2025**
(21) Application number: 23865535.1
(22) Date of filing: 12.09.2023
(51) Int. Cl.: H01L 21/683

(54) **ATTRACTIVE-ADHESION SUBSTRATE**

(30) Priority: 14.09.2022 JP 2022145874
(71) Applicant: Kyocera Corporation, Kyoto-shi, Kyoto 612-8501 (JP)
(72) Inventor: ITO, Masaki, Kyoto-shi, Kyoto 612-8501 (JP); FUJIO, Kazuhiko, Kyoto-shi, Kyoto 612-8501 (JP); KAWANABE, Yasunori, Kyoto-shi, Kyoto 612-8501 (JP)
(74) Representative: Viering, Jentschura & Partner mbB Patent- und Rechtsanwälte
(86) International application number: PCT/JP2023/033252
(87) International publication number: WO 2024/058183

(57) **Abstract**

An adsorption substrate according to the present disclosure includes a base, an adsorption conductive layer, a lead-out section, and a recessed section. The base has a first surface configured to hold an article to be processed, and a second surface located on an opposite side to the first surface. The base is composed of an insulator. The adsorption conductive layer is located inside the base and extends along the first surface. The lead-out section leads out from the adsorption conductive layer to the second surface. The recessed section is located on the second surface. The lead-out section is exposed at the bottom surface of the recessed section. The adsorption conductive layer includes a through section, through which the insulator penetrates, provided in at least one of the inside of the recessed section or the periphery of the recessed section in plane perspective.

## Description

### TECHNICAL FIELD

The disclosed embodiments relate to an adsorption substrate.

### BACKGROUND OF INVENTION

A known electrostatic chuck holds an article to be processed such as a semiconductor wafer. The electrostatic chuck includes an adsorption substrate. The adsorption substrate includes a base. The base has an insulating property. The base is provided with power inside.

### CITATION LIST

### PATENT LITERATURE

Patent Document 1: JP 2015-162481 A
Patent Document 2: JP 2020-25101 A

### SUMMARY

An adsorption substrate according to one aspect of an embodiment includes a base, an adsorption conductive layer, a lead-out section, and a recessed section. The base has a first surface configured to hold an article to be processed, and a second surface located on an opposite side to the first surface. The base is composed of an insulator. The adsorption conductive layer is located inside the base and extends along the first surface. The lead-out section leads out from the adsorption conductive layer to the second surface. The recessed section is located on the second surface. The lead-out section is exposed at the bottom surface of the recessed section. The adsorption conductive layer includes a through section, through which the insulator penetrates, provided in at least one of the inside of the recessed section or the periphery of the recessed section in plane perspective.

### BRIEF DESCRIPTION OF THE DRAWINGS

FIG. 1 is a cross-sectional view illustrating a configuration of an electrostatic chuck having an adsorption substrate according to a first embodiment.
FIG. 2 is a cross-sectional view taken along a line II-II illustrated in FIG. 1.
FIG. 3 is an enlarged view of a through section forming region III illustrated in FIG. 2.
FIG. 4 is a cross-sectional view taken along a line IV-IV illustrated in FIG. 3.
FIG. 5 is an enlarged view of a through section forming region according to a second embodiment.
FIG. 6 is a cross-sectional view taken along a line VI-VI illustrated in FIG. 5.
FIG. 7 is an enlarged view of a through section forming region according to a third embodiment.
FIG. 8 is an enlarged view of a through section forming region according to a fourth embodiment.
FIG. 9 is a cross-sectional view taken along a line IX-IX illustrated in FIG. 8.
FIG. 10 is an enlarged view of a through section forming region according to a fifth embodiment.
FIG. 11 is a cross-sectional view taken along a line XI-XI illustrated in FIG. 10.
FIG. 12 is an enlarged view of a through section forming region according to a sixth embodiment.
FIG. 13 is a cross-sectional view taken along a line XIII-XIII illustrated in FIG. 12.

### DESCRIPTION OF EMBODIMENTS

Embodiments of an adsorption substrate disclosed in the present application will now be described with reference to the accompanying drawings. This disclosure is not limited by the following embodiments.

In the related art, an adsorption substrate used for an electrostatic chuck holding an article to be processed such as a semiconductor wafer, may have a delamination at the interface between the base of the adsorption substrate and the electrode. Thus, providing an adsorption substrate with reduced delamination is expected.

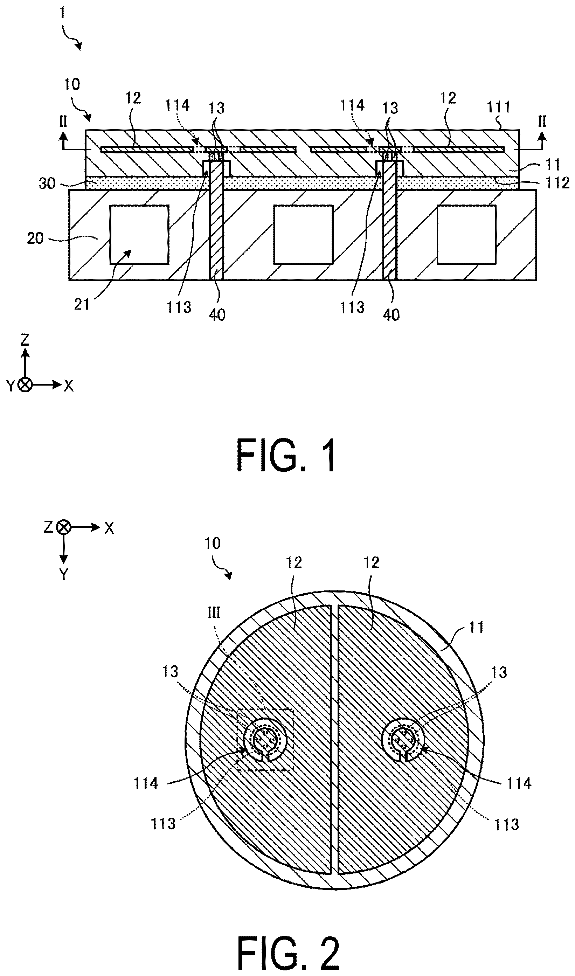

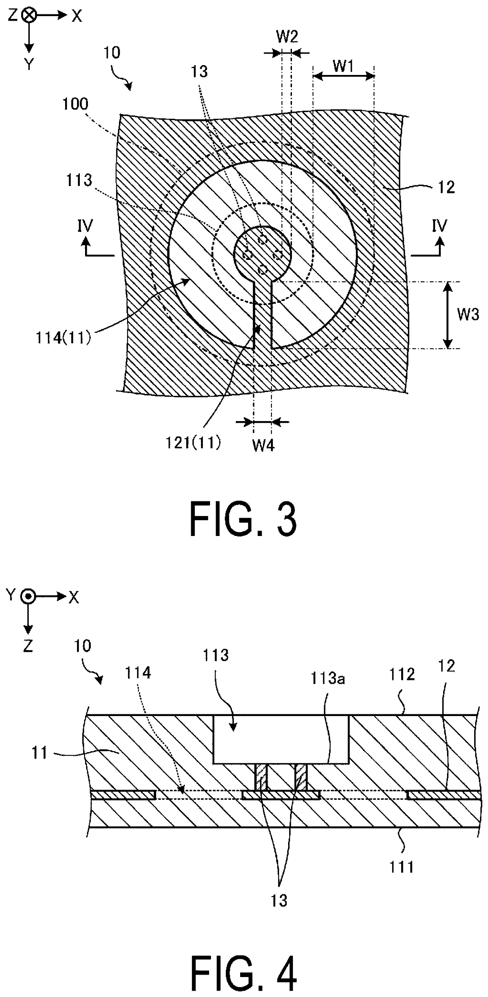

FIG. 1 is a cross-sectional view illustrating a configuration of an electrostatic chuck having an adsorption substrate according to a first embodiment. FIG. 2 is a cross-sectional view taken along the line II-II illustrated in FIG. 1. FIG. 3 is an enlarged view of the through section forming region III illustrated in FIG. 2. FIG. 4 is a cross-sectional view taken along the line IV-IV illustrated in FIG. 3.

An electrostatic chuck 1 includes an adsorption substrate 10, a heat exchanger 20, and a bonding material 30. The electrostatic chuck 1 adsorbs an article to be processed, such as a semiconductor wafer, by using an electrostatic force generated on the surface of the adsorption substrate 10.

The adsorption substrate 10 may be substantially disk shaped, for example. The adsorption substrate 10 may have a disk shape having a diameter of from 50 mm to 400 mm and a thickness of from 2 mm to 15 mm, for example. The adsorption substrate 10 may have a first surface 111 and a second surface 112 facing each other in the thickness direction. The first surface 111 may be a holding surface configured to hold an article to be processed. The second surface 112 may be located on the opposite side to the first surface 111. The second surface 112 may be bonded to the heat exchanger 20 using a bonding material 30.

The adsorption substrate 10 includes a base 11, an adsorption conductive layer 12, a lead-out section 13, a recessed section 113, and a through section 114. The base 11 may have an insulating property. The base 11 may be composed of an insulator. For example, the base 11 may be a ceramic containing inorganic particles such as aluminum oxide (Al₂O₃), aluminum nitride (AlN), and yttria (Y₂O₃) as main constituents.

The adsorption conductive layer 12 is located inside the base 11. The adsorption conductive layer 12 extends near and along the first surface 111. As illustrated in FIG. 2, the adsorption conductive layer 12 is, for example, a bipolar structure having a semicircular shape in which a substantially circular shape is divided into two along a diameter parallel to the Y-axis in plane perspective. The adsorption conductive layer 12 may have, for example, a semicircular-shape diameter in plane perspective of from 30 mm to 398 mm. The adsorption conductive layer 12 may contain, for example, a noble metal such as platinum (Pt) or palladium (Pd) as a main constituent. The adsorption conductive layer 12 is not limited to a noble metal and may contain, for example, tungsten (W) or molybdenum (Mo) as a main constituent.

In the present disclosure, a bipolar structure having two adsorption conductive layers 12 is exemplified. The adsorption conductive layer 12 is not limited to two and may have a monopolar structure having one adsorption conductive layer 12.

The lead-out section 13 may be located inside the base 11. The lead-out section 13 may lead out from the adsorption conductive layer 12 to the second surface 112. The lead-out section 13 may be a columnar via having a substantially circular shape in plane perspective. The shape of the lead-out section 13 in plane perspective is not limited to a substantially circular shape, but may be an elliptical shape or a polygonal shape.

The material of the lead-out section 13 may be the same as that of the adsorption conductive layer 12. Thus, the adsorption substrate 10 may be fabricated without separately preparing the material of the lead-out section 13. The material of the lead-out section 13 may be different from that of the adsorption conductive layer 12 as long as it is a conductive material. The material of the lead-out section 13 may be, for example, a metal material, a carbon material, or the like.

The recessed section 113 may be located on the second surface side 112. One end of the lead-out section 13 may be in contact with the adsorption conductive layer 12. The other end of the lead-out section 13 may be exposed at a bottom surface 113a of the recessed section 113 illustrated in FIG. 4. The other end of the lead-out section 13 may be connected to an externally drawn power supply terminal 40. In that case, the adsorption conductive layer 12 is powered from the power supply terminal 40 through the lead-out section 13. For example, a heater or a high-frequency electrode may be disposed inside the base 11.

The heat exchanger 20 may have a function of receiving heat of the adsorption substrate 10 and radiating heat to the outside. The heat exchanger 20 may be bonded to the second surface 112 of the adsorption substrate 10 by the bonding material 30 such as silicone. The heat exchanger 20 may include a flow path 21 through which a cooling medium flows. The heat exchanger 20 according to a first embodiment may be made of a metal such as aluminum. The heat exchanger 20 may be made of a ceramic such as alumina or silicon carbide.

When the heat exchanger 20 is made of a metal, the heat exchanger 20 may be used as an RF electrode of the adsorption substrate 10. When the heat exchanger 20 is made of a ceramic, a metal layer may be formed on the outer surface of the heat exchanger 20. In this case, the metal layer may be used as an RF electrode of the electrostatic chuck 1.

As described above, one end of the lead-out section 13 of the adsorption substrate 10 may contact the adsorption conductive layer 12. The other end of the lead-out section 13 may be exposed at the bottom surface 113a of the recessed section 113 illustrated in FIG. 4. In a step of forming the recessed section 113, the recessed section 113 may be formed by drilling the base 11 from a predetermined position at the second surface 112 of the base 11 to a depth at which the other end of the lead-out section 13 is exposed.

When such a forming step is used, in the forming step of the recessed section 113, delamination may occur at the interface between the adsorption conductive layer 12 located near the recessed section 113 and the base 11 due to vibration or impact during drilling of the base 11.

The adsorption substrate 10 may also be fabricated by preparing a plurality of sheet-shaped molded articles at each of which conductive paste to be a conductive layer is printed and sheet-shaped molded articles at each of which conductive paste is not printed, layering them, degreasing them, firing them, and polishing them as required. When the adsorption substrate 10 having the recessed section 113 is fabricated, a sheet-shaped molded article lacking a portion to be the recessed section 113 may be layered in advance. When such a forming step is used, deformation is likely to occur around the recessed section 113 due to densification and shrinkage of the molded article in the firing step, and delamination may occur around the lead-out section.

Thus, the adsorption conductive layer 12 according to the first embodiment may include the through section 114, through which the insulator of a base 11 penetrates, provided in at least one of the inside of the recessed section 113 or the periphery of the recessed section 113 in plane perspective. The periphery of the recessed section 113 may be, for example, a region 100 that ranges from the outer edge of the recessed section 113 illustrated in FIG. 3 to the outside by a predetermined distance W1. The predetermined distance W1 may be, for example, 5 mm. The predetermined distance W1 may be, for example, 3 mm. The predetermined distance W1 may be, for example, 1 mm.

Note that the plane perspective here does not mean the case where a visible image of the adsorption substrate 10 is viewed from the first surface 111 side, but may mean, for example, the case where an X-ray image of the adsorption substrate 10 is viewed from the first surface 111 side. That is, the plane perspective here may mean the case where the inside of the adsorption substrate 10 is viewed from the first surface 111 side.

As illustrated in FIG. 2, the through section forming region III in which the through section 114 is provided may be provided at a position in the center of the adsorption conductive layer 12 having a semicircular shape in plane perspective. The through section forming region III may be provided at a position near the center of gravity of the adsorption conductive layer 12 having a semicircular shape in plane perspective.

This enables the adsorption substrate 10 to firmly connect the insulator located closer to the first surface 111 than the adsorption conductive layer 12 and the insulator located closer to the second surface 112 than the adsorption conductive layer 12 by the insulator of the through section 114.

Thus, according to the adsorption substrate 10, even when the base 11 vibrates or receives an impact during drilling of the base 11 in the process of forming the recessed section 113, delamination can be suppressed from occurring at the interface between the adsorption conductive layer 12 and the base 11, which are located near the recessed section 113.

As illustrated in FIGs. 3 and 4, the lead-out section 13 may be located inside the recessed section 113 in plane perspective. In the example illustrated in FIGs. 3 and 4, four lead-out sections 13 each having a substantially circular columnar shape in plane perspective are provided at equal intervals around the center of the bottom surface 113a of the recessed section 113 in plane perspective. The diameter of each of the lead-out sections 13 in plane perspective may be, for example, from 0.5 to 1.0 mm. The number of the lead-out sections 13 may be three or less, or five or more. The plane perspective shape of the lead-out section 13 is not limited to a substantially circular shape, but may be an elliptical shape or a polygonal shape.

The through section 114 has a predetermined width W3 and an arc shape in plane perspective where a part of the periphery surrounding the lead-out section 13 is open by a predetermined distance W4. The predetermined width W3 may be, for example, 2.0 mm or more. The predetermined distance W4 may be, for example, from 0.5 to 3.0 mm. The inner periphery of the through section 114 is located inside the recessed section 113. The outer periphery of the through section 114 may be located outside the recessed section 113. The shortest distance from the lead-out section 13 to the inner periphery of the through section 114 may be, for example, from 0.5 to 1.0 mm.

The lead-out section 13 located inside the inner periphery of the through section 114 and the adsorption conductive layer 12 located outside the outer periphery of the through section 114 may be connected by a connecting section 121 having a width of the predetermined distance W4 located at the opening of the through section 114. Thus, power is supplied from the power supply terminal 40 through the lead-out section 13 and the connecting section 121 to the entire adsorption conductive layer 12.

The through section 114 illustrated in FIGs. 1 to 4, enables firm connection of the insulator located closer to the first surface 111 than the adsorption conductive layer 12 and the insulator located closer to the second surface 112 than the adsorption conductive layer 12 by the insulator of the through section 114 located inside and in the periphery of the recessed section 113 in plane perspective. This enables the adsorption substrate 10 to reduce the occurrence of delamination at the interface between the adsorption conductive layer 12 and the base 11.

The shape and arrangement of the lead-out section 13 and the through section 114 are not limited to the shape and arrangement of the lead-out section 13 and the through section 114 illustrated in FIGs. 1 to 4, and various modifications are possible. Hereinafter, the shape and arrangement of the lead-out section 13 and the through section 114 according to the second to sixth embodiments will be described. In the second to sixth embodiments described below, the through section forming region in the adsorption conductive layer 12 may be provided in the same position as the through section forming region III illustrated in FIG. 2.

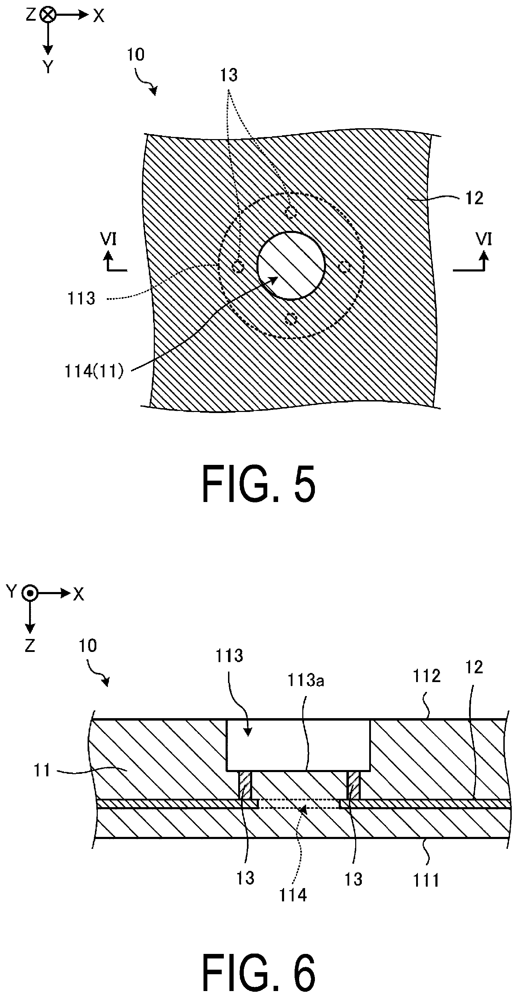

FIG. 5 is an enlarged view of the through section forming region according to a second embodiment. FIG. 6 is a cross-sectional view taken along the line VI-VI illustrated in FIG. 5. As illustrated in FIGs. 5 and 6, the through section 114 according to the second embodiment may be located inside the recessed section 113 in plane perspective.

The through section 114 according to the second embodiment may be substantially circular in plane perspective. The plane perspective shape of the through section 114 according to the second embodiment is not limited to a substantially circular shape, but may be an elliptical shape or a polygonal shape.

The lead-out section 13 according to the second embodiment is located outside the outer periphery of the through section 114 and inside the recessed section 113 in plane perspective. In the example illustrated in FIG. 5, the four lead-out sections 13 may be provided at equal intervals around the center of the bottom surface 113a of the recessed section 113 in plane perspective. The four lead-out sections 13 may each have a columnar shape having a substantially circular shape in plane perspective.

The diameter of the lead-out section 13 according to the second embodiment in plane perspective may be, for example, from 0.5 to 1.0 mm. The number of the lead-out sections 13 may be three or less, or five or more. The plane perspective shape of the lead-out section 13 according to the second embodiment is not limited to a substantially circular shape, but may be an elliptical shape or a polygonal shape. The shortest distance from the through section 114 to the lead-out section 13 according to the second embodiment may be, for example, from 0.5 to 1.0 mm.

The through section 114 according to the second embodiment, enables firm connection of the insulator located closer to the first surface 111 than the adsorption conductive layer 12 and the insulator located closer to the second surface 112 than the adsorption conductive layer 12 by the insulator of the through section 114 located inside the recessed section 113 in plane perspective. This makes the adsorption substrate 10 less prone to delamination at the interface between the adsorption conductive layer 12 and the base 11.

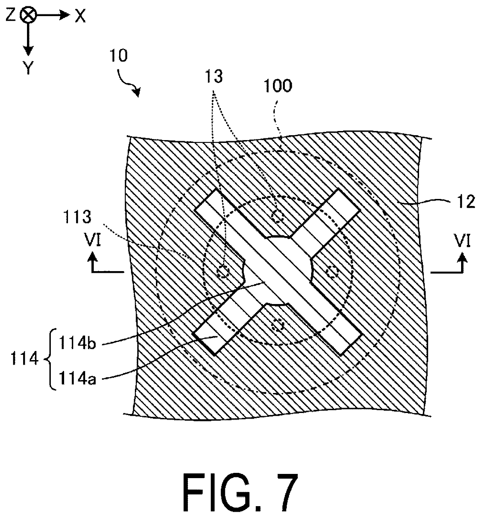

FIG. 7 is an enlarged view of the through section forming region according to a third embodiment. The cross-sectional view along the line VI-VI illustrated in FIG. 7 of the through section forming region according to the third embodiment is the same as the cross-sectional view illustrated in FIG. 6, so illustration thereof is omitted here.

As illustrated in FIG. 7, the through section 114 according to the third embodiment may have an X-shape in which two line sections 114a each having a predetermined width intersect in plane perspective. The predetermined width may be, for example, 2 mm or more. In the through section 114 according to the third embodiment, an intersecting section 114b of the two line sections 114a may be located in the center of the recessed section 113, and respective both ends of the two line sections 114a may be located outside the recessed section 113. Respective both ends of the two line sections 114a may project outward from the outer periphery of the recessed section 113 by, for example, 2 mm in plane perspective.

The lead-out section 13 according to the third embodiment is located in a region inside the recessed section 113 and bound in two directions by the two line sections 114a of the through section 114 in plane perspective. In the example illustrated in FIG. 7, the four lead-out sections 13 may be provided at equal intervals around the center of the bottom surface 113a of the recessed section 113 in plane perspective. The four lead-out sections 13 may each have a columnar shape having a substantially circular shape in plane perspective. The diameter of the lead-out section 13 according to the third embodiment in plane perspective may be, for example, from 0.5 to 1.0 mm.

The number of the lead-out sections 13 according to the third embodiment may be 3 or less, or 5 or more. The plane perspective shape of the lead-out section 13 is not limited to a substantially circular shape, but may be an elliptical shape or a polygonal shape. The shortest distance from the lead-out section 13 according to the third embodiment to the intersecting section 114b of the two line sections 114a at the through section 114 may be, for example, from 0.5 to 1.0 mm.

The through section 114 according to the third embodiment, enables firm connection of the insulator located closer to the first surface 111 than the adsorption conductive layer 12 and the insulator located closer to the second surface 112 than the adsorption conductive layer 12 by the insulator of the through section 114 located inside the recessed section 113 in plane perspective. This makes the adsorption substrate 10 less prone to delamination at the interface between the adsorption conductive layer 12 and the base 11.

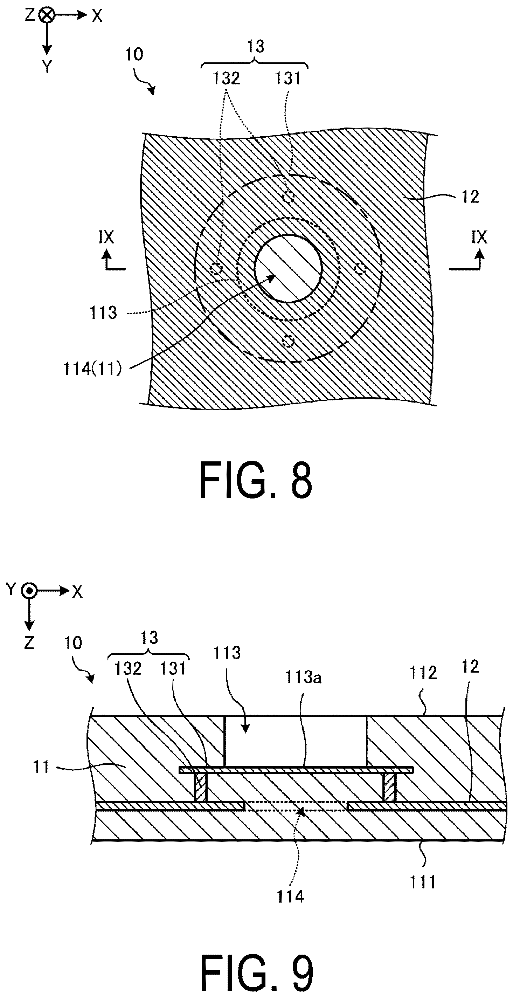

FIG. 8 is an enlarged view of the through section forming region according to a fourth embodiment. FIG. 9 is a cross-sectional view taken along the IX-IX line illustrated in FIG. 8. As illustrated in FIGs. 8 and 9, the through section 114 according to the fourth embodiment may be located inside the recessed section 113 in plane perspective. The distance from the outer periphery of the through section 114 according to the fourth embodiment to the outer periphery of the recessed section 113 may be, for example, from 0.5 to 2.0 mm.

The through section 114 according to the fourth embodiment may have a substantially circular shape in plane perspective. The plane perspective shape of the through section 114 according to the fourth embodiment is not limited to a substantially circular shape, but may be an elliptical shape or a polygonal shape.

The lead-out section 13 according to the fourth embodiment may have a first portion 131 and a second portion 132. The first portion 131 may have a substantially circular shape in plane perspective with a portion that is exposed at the bottom surface 113a of the recessed section 113 and with an outer periphery extending to the outside of the recessed section 113 in plane perspective. The plane perspective shape of the first portion 131 is not limited to a substantially circular shape, but may be an elliptical shape or a polygonal shape.

The second portion 132 may be a via. In this case, the via may be located outside the recessed section 113 and inside the outer periphery of the first portion 131 in plane perspective, with one end connected to the first portion 131 and the other end connected to the adsorption conductive layer 12. The diameter of the second portion 132 in plane perspective may be, for example, from 0.5 to 1.0 mm. The distance from the second portion 132 to the outer periphery of the recessed section 113 may be, for example, from 0.5 to 1.0 mm. The distance from the second portion 132 to the outer periphery of the first portion 131 may be, for example, from 0.5 to 1.0 mm.

The through section 114 according to the fourth embodiment, enables firm connection of the insulator located closer to the first surface 111 than the adsorption conductive layer 12 and the insulator located closer to the second surface 112 than the adsorption conductive layer 12 by the insulator of the through section 114 located inside the recessed section 113 in plane perspective. This makes the adsorption substrate 10 less prone to delamination at the interface between the adsorption conductive layer 12 and the base 11.

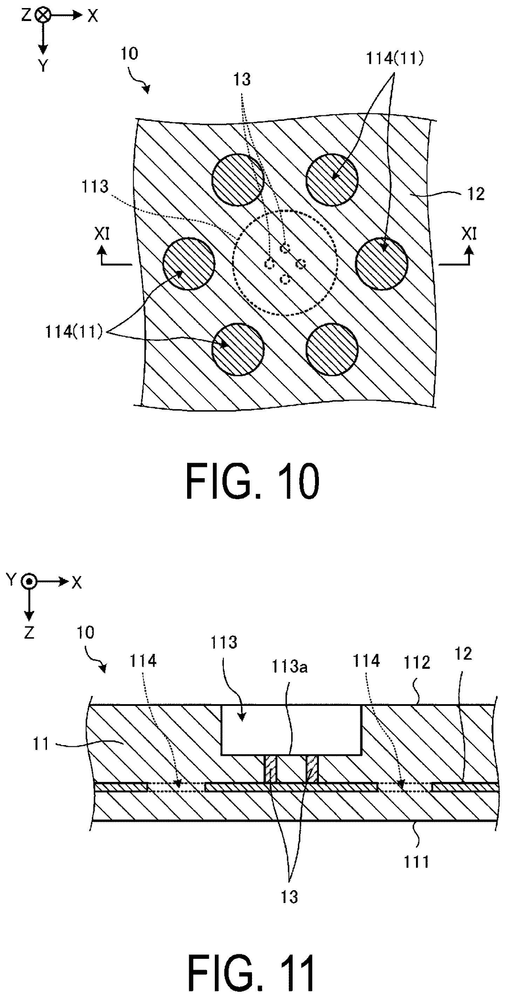

FIG. 10 is an enlarged view of the through section forming region according to a fifth embodiment. FIG. 11 is a cross-sectional view taken along the line XI-XI illustrated in FIG. 10. As illustrated in FIGs. 10 and 11, the lead-out section 13 according to the fifth embodiment may be located inside the recessed section 113 in plane perspective. In the example illustrated in FIG. 10, the four lead-out sections 13 may be provided at equal intervals around the center of the bottom surface 113a of the recessed section 113 in plane perspective. The four lead-out sections 13 may each have a columnar shape having a substantially circular shape in plane perspective.

The diameter of each of the lead-out sections 13 according to the fifth embodiment in plane perspective may be, for example, from 0.5 to 1.0 mm. The number of the lead-out sections 13 according to the fifth embodiment may be 3 or less, or 5 or more. The plane perspective shape of the lead-out section 13 according to the fifth embodiment is not limited to a substantially circular shape, but may be an elliptical shape or a polygonal shape.

The through section 114 according to the fifth embodiment is located outside the recessed section 113 in plane perspective. A plurality of through sections 114 according to the fifth embodiment may be arranged so as to surround the four lead-out sections 13. In the example illustrated in FIG. 10, the six through sections 114 may be arranged so as to surround the four lead-out sections 13 around the center of the bottom surface 113a of the recessed section 113 in plane perspective. The six through sections 114 may have a substantially circular shape in plane perspective.

The plane perspective shape of the through section 114 according to the fifth embodiment is not limited to a substantially circular shape, but may be an elliptical shape or a polygonal shape. The number of the through sections 114 according to the fifth embodiment may be 5 or less, or 7 or more. The diameter of the through section 114 according to the fifth embodiment in plane perspective may be, for example, from 2.0 to 4.0 mm. The distance from the recessed section 113 to the through section 114 according to the fifth embodiment may be, for example, from 0 to 2.0 mm.

The through section 114 according to the fifth embodiment, enables firm connection of the insulator located closer to the first surface 111 than the adsorption conductive layer 12 and the insulator located closer to the second surface 112 than the adsorption conductive layer 12 by the insulator of the through section 114 located in the periphery of the recessed section 113 in plane perspective. This makes the adsorption substrate 10 less prone to delamination at the interface between the adsorption conductive layer 12 and the base 11.

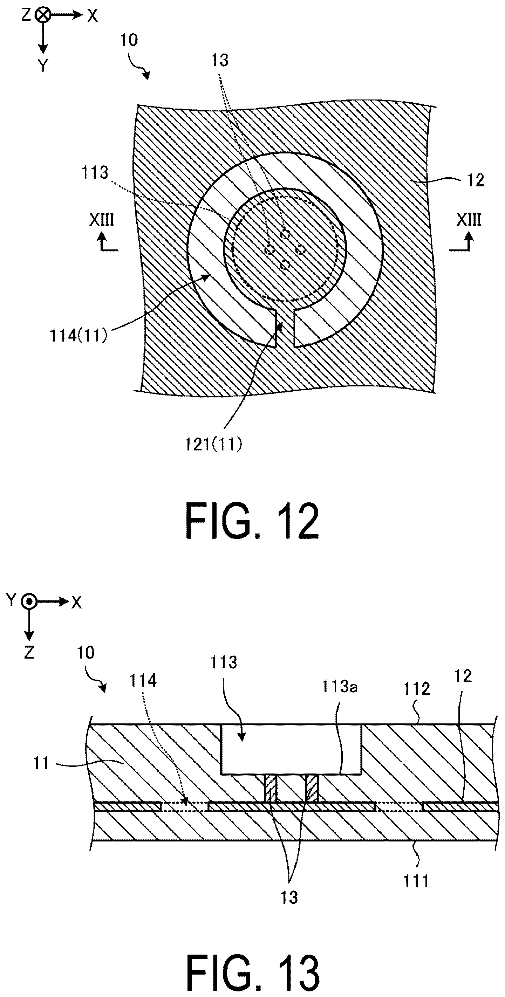

FIG. 12 is an enlarged view of the through section forming region according to a sixth embodiment. FIG. 13 is a cross-sectional view taken along line XIII-XIII illustrated in FIG. 12. As illustrated in FIGs. 13 and 14, the lead-out section 13 according to the sixth embodiment is located inside the recessed section 113 in plane perspective. In the example illustrated in FIG. 12, the 4 lead-out sections 13 may be provided at equal intervals around the center of the bottom surface 113a of the recessed section 113 in plane perspective. The four lead-out sections 13 may each have a columnar shape having a substantially circular shape in plane perspective.

The diameter of each of the lead-out sections 13 according to the sixth embodiment in plane perspective may be, for example, from 0.5 to 1.0 mm. The number of the lead-out sections 13 according to the sixth embodiment may be three or less, or five or more. The plane perspective shape of the lead-out section 13 according to the sixth embodiment is not limited to a substantially circular shape, but may be an elliptical shape or a polygonal shape.

The through section 114 according to the sixth embodiment may have a predetermined width and an arc shape in plane perspective where a part of the periphery surrounding the lead-out section 13 is open by a predetermined distance. The predetermined width may be, for example, from 2.0 mm or more. The predetermined distance may be, for example, from 0.5 to 3.0 mm. The inner periphery of the through section 114 according to the sixth embodiment is located outside the recessed section 113. In plane perspective, the distance from the inner periphery of the through section 114 according to the sixth embodiment to the outer periphery of the recessed section 113 may be from 0 to 2.0 mm.

The through section 114 according to the sixth embodiment, enables firm connection of the insulator located closer to the first surface 111 than the adsorption conductive layer 12 and the insulator located closer to the second surface 112 than the adsorption conductive layer 12 by the insulator of the through section 114 located in the periphery of the recessed section 113 in plane perspective. This makes the adsorption substrate 10 less prone to delamination at the interface between the adsorption conductive layer 12 and the base 11.

### REFERENCE SIGNS

1 Electrostatic chuck
10 Adsorption substrate
11 Base
111 First surface
112 Second surface
113 Recessed section
113a Bottom surface of recessed section
114 Through section
114a Line section
114b Intersecting section
12 Adsorption conductive layer
121 Connecting section
13 Lead-out section
20 Heat exchanger
21 Flow path
30 Bonding material
40 Power supply terminal
131 First portion
132 Second portion

## Claims

1. An adsorption substrate, comprising:
a base;
an adsorption conductive layer; and
a lead-out section, wherein
the base comprises an insulator having an insulating property, has a first surface configured to hold an article to be processed and a second surface located on an opposite side to the first surface and has a recessed section at the second surface,
the adsorption conductive layer is located inside the base and extends along the first surface,
the lead-out section leads out from the adsorption conductive layer to the second surface; and is exposed at the bottom surface of the recessed section, and
the adsorption conductive layer comprises a through section through which the insulator penetrates, and that is provided in at least one of the inside of the recessed section or the periphery of the recessed section in plane perspective.

2. The adsorption substrate according to claim 1, wherein
the lead-out section is located inside the recessed section in plane perspective, and
the through section has a predetermined width and forms an arc shape that surrounds the lead-out section in plane perspective, the arc shape comprising an inner periphery located inside the recessed section; an outer periphery located outside the recessed section; and an opening that spans a part of both the inner and outer peripheries.

3. The adsorption substrate according to claim 1, wherein
the through section is located inside the recessed section in plane perspective, and
the lead-out section is located in plane perspective outside the outer periphery of the through section and inside the recessed section.

4. The adsorption substrate according to claim 1, wherein
the through section has an X-shape formed by two line sections intersecting, each line section having a predetermined width in plane perspective, the intersection of the two line sections being located at the center of the recessed section, both ends of each of the two line sections are located outside the recessed section, and
the lead-out section is located in plane perspective in a region that is inside the recessed section and bound in two directions by the two line sections.

5. The adsorption substrate according to claim 1, wherein
the through section is located inside the recessed section in plane perspective, and
the lead-out section comprises a first portion and a second portion, the first portion, in plane perspective, comprising a part that is exposed at the bottom surface of the recessed section and having an outer periphery extending to the outside of the recessed section, and the second portion, in plane perspective, being located outside the recessed section and inside the outer periphery of the first portion and having one end connected to the first portion and the other end connected to the adsorption conductive layer.

6. The adsorption substrate according to claim 1, wherein
the lead-out section is located inside the recessed section in plane perspective, and
the through section, in plane perspective, is located outside the recessed section, and comprises a plurality of sections that are arranged surrounding the lead-out section.

7. The adsorption substrate according to claim 1, wherein
the lead-out section is located inside the recessed section in plane perspective, and
the through section has a predetermined width and forms an arc shape that surrounds the lead-out section in plane perspective, the arc shape comprising an inner periphery located outside the recessed section; and an opening that spans a part of the arc shape.
